(19) **Europäisches Patentamt / European Patent Office / Office européen des brevets**

(11) **EP 3 654 242 B1**

(12) **FASCICULE DE BREVET EUROPEEN**

(45) Date de publication et mention
de la délivrance du brevet:
**28.01.2026 Bulletin 2026/05**

(51) Classification Internationale des Brevets (IPC):
***G06V 40/13*** *(2022.01)*

(52) Classification Coopérative des Brevets (CPC):
**G06V 40/1306**

(21) Numéro de dépôt: **19217130.4**

(22) Date de dépôt: **27.07.2017**

(54) **CAPTEUR DE MOTIF THERMIQUE ACTIF COMPRENANT UNE MATRICE PASSIVE DE PIXELS**

SENSOR FÜR AKTIVES WÄRMEMUSTER, DAS EINE PASSIVE PIXELMATRIX UMFASST

ACTIVE THERMAL PATTERN SENSOR COMPRISING A PASSIVE ARRAY OF PIXELS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.07.2016 FR 1657391**

(43) Date de publication de la demande:
**20.05.2020 Bulletin 2020/21**

(62) Numéro(s) de document de la (des) demande(s) initiale(s) en application de l'article 76 CBE:
**17754417.8 / 3 308 326**

(73) Titulaires:
• **Commissariat à l'Energie Atomique et aux Energies Alternatives
75015 Paris (FR)**
• **IDEMIA Public Security France
92400 Courbevoie (FR)**

(72) Inventeurs:
• **MAINGUET, Jean-François
38100 GRENOBLE (FR)**
• **FOURRE, Joël Yann
77550 MOISSY-CRAMAYEL (FR)**
• **SEGURA PUCHADES, Josep
38600 FONTAINE (FR)**

(74) Mandataire: **IPS
2, place Samuel de Champlain
92400 Courbevoie (FR)**

(56) Documents cités:
**EP-A1- 0 840 250     EP-A1- 2 385 486
EP-A2- 1 469 415**

• **ANONYMOUS: "Active pixel sensor - Wikipedia", 15 June 2016 (2016-06-15), XP055367419, Retrieved from the Internet <URL:https://en.wikipedia.org/w/index.php?title=Active_pixel_sensor&oldid=725362379> [retrieved on 20170425]**

**Description**

**DOMAINE TECHNIQUE ET ART ANTÉRIEUR**

L'invention porte sur un capteur de motif thermique, par exemple un capteur d'empreintes digitales, réalisant une détection thermique active et comprenant une matrice passive de pixels.

Un capteur d'empreintes digitales comporte des moyens de détection thermique. Ces moyens de détection thermique peuvent correspondre à des éléments pyroélectriques, des diodes, des thermistances ou tout autre élément sensible à la température permettant de convertir une variation de température en une variation de potentiel ou de courant électrique.

La détection d'une empreinte digitale peut être réalisée par des capteurs dits « passifs » exploitant une différence de températures entre le doigt et le capteur, comme décrit dans les documents US 4 394 773, US 4 429 413 et US 6 289 114. Ces capteurs ont toutefois pour inconvénient de réaliser une mesure qui dépend uniquement de la différence de températures entre le doigt et le capteur. Il peut donc arriver que le niveau du signal obtenu soit nul lorsque le doigt et le capteur sont à la même température (par exemple lorsque le doigt reste un certain temps sur le capteur), ou que le contraste des images capturées varie et pose alors des problèmes lors du traitement ultérieur des images.

Pour éliminer les problèmes soulevés par les capteurs thermiques passifs, notamment dans le cas d'une acquisition statique où le doigt ne bouge pas, des capteurs d'empreintes dits « actifs » ont été proposés, comme par exemple celui décrit dans les documents US 6 091 837 et EP 2 385 486 A1. Dans un tel capteur, chaque pixel comporte une capacité pyroélectrique formée de deux électrodes conductrices entre lesquelles une portion de matériau pyroélectrique est disposée, et un élément chauffant. Cet élément chauffant dissipe une certaine quantité de chaleur dans le pixel, et l'échauffement du pixel est mesuré au bout d'un certain temps d'acquisition, appelé temps d'intégration, en présence du doigt sur le capteur. Cela permet de distinguer, au niveau de chaque pixel, la présence d'une crête ou d'une vallée de l'empreinte détectée suivant que la chaleur est absorbée par la peau (pixel en présence d'une crête de l'empreinte) ou conservée dans le pixel (pixel en présence d'une vallée de l'empreinte). Cela conduit à une température finale plus faible dans le cas d'un pixel en présence d'une crête, où la chaleur est absorbée par la peau, par rapport à un pixel en présence d'une vallée.

Au premier ordre, un tel capteur permet de mesurer la capacité calorifique, également appelée chaleur massique ou capacité thermique massique, d'un élément en contact avec le capteur. Les mesures obtenues dépendent également de la conductivité thermique entre le capteur et la partie de l'élément (crête ou vallée dans le cas d'une empreinte digitale) en présence.

Pour former un capteur thermique actif, les pixels de ce capteur sont couplés à des éléments chauffants utilisant généralement l'effet Joule qui dissipe de la chaleur depuis un élément résistif qui est parcouru par un courant. Un des niveaux de l'empilement technologique formant les pixels est avantageusement utilisé pour former ces éléments chauffants. Par exemple, il possible d'utiliser un des niveaux électriquement conducteurs servant à réaliser les transistors et les interconnexions du capteur si l'un de ces niveaux comporte un matériau conducteur présentant une résistivité adéquate et sur lequel il suffit d'appliquer une des tensions déjà disponibles, par exemple la tension d'alimentation du capteur, pour générer un chauffage par effet Joule. Cela est notamment utilisé lorsque le capteur comporte des transistors de type TFT (« Thin-Film Transistor », ou transistor en couches minces) réalisés sur un substrat de verre ou de plastique.

Les pixels d'un tel capteur sont disposés en formant une matrice de plusieurs lignes et de plusieurs colonnes. La lecture des pixels est généralement réalisée ligne par ligne. Les éléments chauffants peuvent alors être également commandés par ligne à l'aide d'un transistor se trouvant en tête de chaque ligne, évitant ainsi l'ajout de transistors de commande dans chacun des pixels. Chaque ligne d'éléments chauffants est par exemple connectée, d'un côté de la matrice de pixels, à la masse, et de l'autre coté au transistor de commande associé à la ligne de pixels et relié à une alimentation adaptée de manière à maîtriser le courant parcourant les éléments chauffants, et donc la puissance thermique injectée par effet Joule dans les pixels par ces éléments chauffants.

Pour réaliser une lecture de la variation du nombre de charges électriques apparaissant dans la capacité pyroélectrique de chaque pixel d'un capteur thermique actif, chacun des pixels comporte au moins un transistor de sélection, et les transistors de sélection des pixels de chaque colonne de pixels sont reliés à une ligne conductrice elle-même relié à un circuit de lecture. Lors de la lecture d'une ligne de pixels, les transistors de sélection des pixels de cette ligne sont mis à l'état passant, ce qui permet de relier les nœuds actifs des pixels de cette ligne aux circuits de lecture se trouvant en pied de chacune des colonnes de pixels. Les transistors de sélection bloqués des pixels appartenant aux autres lignes de pixels empêchent le déplacement de charges depuis ces autres pixels vers les circuits de lecture. D'autres transistors peuvent également être présents dans chaque pixel, notamment lorsque les pixels sont lus en tension et qu'ils nécessitent la présence d'un transistor de réinitialisation et d'un transistor suiveur de tension, ou que le capteur forme également un capteur optique dans lequel un transistor est présent dans chaque pixel pour relier une photodiode de chaque pixel à un circuit de lecture dédié.

Or, la présence de ces transistors au sein de la matrice de pixels représente une contrainte technologique et un coût important dans la réalisation du capteur.

## EXPOSÉ DE L'INVENTION

Un but de la présente invention est de proposer un capteur de motif thermique actif, c'est-à-dire comportant des éléments chauffants les pixels du capteur, comportant une matrice passive de pixels, c'est-à-dire dont la structure permet une lecture des pixels sans faire appel à des transistors présents dans chacun des pixels.

Pour cela, l'invention propose un capteur de motif thermique comportant une matrice de plusieurs lignes et colonnes de pixels, chaque pixel comprenant au moins :

- une capacité pyroélectrique formée par au moins une portion de matériau pyroélectrique disposée entre une électrode inférieure et une électrode supérieure, dans laquelle une première des électrodes inférieure et supérieure correspond à une électrode de lecture du pixel, et

- un élément chauffant apte à chauffer la portion de matériau pyroélectrique de la capacité pyroélectrique dudit pixel lors d'une mesure du motif thermique par la capacité pyroélectrique dudit pixel,
  et dans lequel :
- pour chaque ligne de pixels, les éléments chauffants des pixels de ladite ligne sont aptes à chauffer les portions de matériau pyroélectrique des pixels de ladite ligne indépendamment des éléments chauffants des pixels des autres lignes, réalisant ainsi une sélection de ladite ligne de pixels pour une mesure du motif thermique par les capacités pyroélectriques des pixels de ladite ligne, et
- pour chaque colonne de pixels, les électrodes de lecture de chaque pixel de ladite colonne sont reliées électriquement entre elles et formées par au moins une première portion électriquement conductrice en contact avec les portions de matériau pyroélectrique des pixels de ladite colonne et distincte des premières portions électriquement conductrices formant les électrodes de lecture des pixels des autres colonnes.

Ce capteur correspond à un capteur actif (car comprenant des pixels chauffés) réalisé avec une matrice de pixels passive, c'est-à-dire sans transistors présents au sein des pixels. Ainsi, la réalisation de ce capteur n'est pas limitée par la technologie nécessaire à la réalisation de transistors au sein de la matrice de pixels, et peut mettre en œuvre des étapes adaptées à une réalisation sur un substrat semi-conducteur tel que du silicium, ou un substrat sur verre, mais également être réalisé en technologie électronique imprimée, par exemple sur un substrat souple.

Sans transistor au sein de la matrice de pixels, la fabrication de la matrice de pixels est simplifiée et se résume à la capacité de réaliser des réseaux de lignes conductrices parallèles à la résolution souhaitée. Ceci devient possible avec des procédés moins onéreux que la lithographie sur semi-conducteur : lithographies telles que celles mises en œuvre pour la réalisation de circuits imprimés, impression (héliogravure, offset gravure...), des structurations laser, etc. Les différentes portions conductrices formant les éléments des pixels du capteur peuvent être réalisées avec des encres conductrices suffisamment stables pour ne pas nécessiter d'encapsulation très performante. La réalisation à très bas coût du capteur est envisageable par impression, par exemple sur des substrats plastiques simples (films PET).

Le capteur selon l'invention réalise une détection thermique et ne correspond pas à un capteur de type capacitif car dans le capteur selon l'invention, ce sont les charges pyroélectriques générées qui sont lues et non une valeur de capacité. Aucune injection de charges n'est réalisée dans le capteur selon l'invention.

Un tel capteur a également pour avantage de réduire le nombre de signaux nécessaires à son pilotage du fait que la sélection de ligne de pixels est réalisée par l'intermédiaire du chauffage des pixels qui est réalisé ligne par ligne.

L'élément comprenant le motif thermique destiné à être détecté par le capteur est destiné à être contact physique avec le capteur, c'est-à-dire disposé contre le capteur lors de la détection de ce motif thermique.

Pour chaque ligne de pixels, les éléments chauffants des pixels de ladite ligne sont aptes à être commandés indépendamment des éléments chauffants des pixels des autres lignes.

Selon un mode de réalisation, le capteur de motif thermique peut être tel que :

- dans chaque pixel, une deuxième des électrodes inférieure et supérieure correspond à une électrode de polarisation du pixel distincte des éléments chauffants, et
- dans chaque ligne de pixels, les éléments chauffants et les électrodes de polarisation des pixels de ladite ligne sont juxtaposés et disposés sur ou sous les portions de matériau pyroélectrique des pixels de ladite ligne.

Selon un autre mode de réalisation, le capteur de motif thermique peut être tel que dans chaque ligne de pixels, au moins une deuxième portion électriquement conductrice forme à la fois l'élément chauffant et une deuxième des électrodes inférieure et supérieure de chacun des pixels de ladite ligne.

Le capteur peut comporter en outre une couche diélectrique recouvrant l'électrode supérieure de chaque pixel de la matrice et une première couche électriquement conductrice disposée sur ladite couche diélectrique. Cette première couche électriquement conductrice forme un blindage électromagnétique du capteur permettant de réduire le bruit électromagnétique provenant par exemple du doigt posé sur le capteur.

Selon un autre mode de réalisation, le capteur peut être tel que:

- une deuxième des électrodes inférieure et supérieure de chaque pixel est formée par une deuxième couche électriquement conductrice commune à tous les pixels de la matrice et apte à être reliée électriquement à un potentiel électrique de référence, et
- dans chaque ligne de pixels, au moins une deuxième portion électriquement conductrice peut former les éléments chauffants des pixels.

Dans ce cas, la deuxième couche électriquement conductrice forme une couche de blindage électromagnétique du capteur.

La deuxième couche électriquement conductrice peut être disposée entre les éléments chauffants et les électrodes de lecture. Dans ce cas, la deuxième couche électriquement conductrice forme à la fois les deuxièmes électrodes et une couche de blindage électromagnétique.

Chaque deuxième portion électriquement conductrice peut également comporter, dans chaque pixel, des parties dont la résistance électrique est supérieure à celle du reste de ladite deuxième portion électriquement conductrice. Une telle configuration est avantageuse et permet de limiter la diathermie entre les pixels du capteur.

Pour chaque ligne de pixels, les éléments chauffants de chaque pixel de ladite ligne peuvent être reliés électriquement entre eux et formés par au moins une deuxième portion électriquement conductrice distincte des éléments chauffants des autres lignes de pixels et apte à chauffer simultanément toutes les portions de matériau pyroélectrique des pixels de ladite ligne.

De manière avantageuse, les électrodes de lecture peuvent correspondre aux électrodes inférieures des pixels. Dans ce cas, l'élément comprenant le motif thermique destiné à être détecté par le capteur est destiné à être contact avec le capteur du côté des électrodes supérieures des pixels, c'est-à-dire du côté de la face avant du capteur, par exemple sur une couche de protection recouvrant le capteur.

Toutefois, il est possible que les électrodes de lecture correspondent aux électrodes supérieures des pixels. Dans ce cas, l'élément comprenant le motif thermique destiné à être détecté par le capteur est destiné à être contact avec le capteur du côté des électrodes inférieures des pixels, c'est-à-dire du côté de la face arrière du capteur, par exemple contre la face arrière du substrat sur lequel les différents éléments du capteur sont réalisés.

Chacun des éléments chauffants peut comporter plusieurs portions électriquement conductrices superposées.

L'invention porte également sur un procédé de réalisation d'un capteur de motif thermique comportant une matrice de plusieurs lignes et colonnes de pixels, comprenant au moins la mise en œuvre des étapes suivantes :

- réalisation, pour chaque pixel, d'une capacité pyroélectrique formée par au moins une portion de matériau pyroélectrique disposée entre une électrode inférieure et une électrode supérieure, dans lequel une première des électrodes inférieure et supérieure correspond à une électrode de lecture du pixel, et
- réalisation d'un élément chauffant apte à chauffer la portion de matériau pyroélectrique de la capacité pyroélectrique dudit pixel lors d'une mesure du motif thermique par la capacité pyroélectrique dudit pixel,

et dans lequel :

- pour chaque ligne de pixels, les éléments chauffants des pixels de ladite ligne sont aptes à chauffer les portions de matériau pyroélectrique des pixels de ladite ligne indépendamment des éléments chauffants des pixels des autres lignes, réalisant ainsi une sélection de ladite ligne de pixels pour une mesure du motif thermique par les capacités pyroélectriques des pixels de ladite ligne, et

- pour chaque colonne de pixels, les électrodes de lecture de chaque pixel de ladite colonne sont reliées électriquement entre elles et formées par au moins une première portion électriquement conductrice en contact avec les portions de matériau pyroélectrique des pixels de ladite colonne et distincte des premières portions électriquement conductrices formant les électrodes de lecture des pixels des autres colonnes.

La réalisation des électrodes inférieures des pixels et/ou des électrodes supérieures des pixels et/ou des éléments chauffants des pixels peut comporter la mise en œuvre d'au moins un dépôt par impression d'au moins un matériau électriquement conducteur, avantageusement une encre électriquement conductrice.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente une vue en coupe d'une partie d'un pixel d'un capteur de motif thermique, objet de la présente invention ;
- la figure 2 représente une vue de dessus d'une partie d'un capteur de motif thermique, objet de la présente invention, selon un premier mode de réalisation ;
- la figure 3 représente un exemple de réalisation d'un circuit de lecture associé à une colonne de pixels d'un capteur de motif thermique, objet de la présente invention ;
- la figure 4 représente une vue de dessus d'une partie d'un capteur de motif thermique, objet de la présente invention, selon un deuxième mode de réalisation ;
- la figure 5 représente une vue de dessus d'une partie d'un capteur de motif thermique, objet de la présente invention, selon un troisième mode de réalisation ;
- la figure 6 représente une vue de dessus d'une partie d'un capteur de motif thermique, objet de la présente invention, selon une variante des deuxième et troisième modes de réalisation ;
- la figure 7 représente une vue en coupe d'une partie d'un pixel d'un capteur de motif thermique, objet de la présente invention, selon une variante de réalisation ;
- la figure 8 représente le nombre de bits de poids faible lus sur un convertisseur analogique/numérique du circuit de la figure 3, en fonction de la puissance injectée par pixel.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

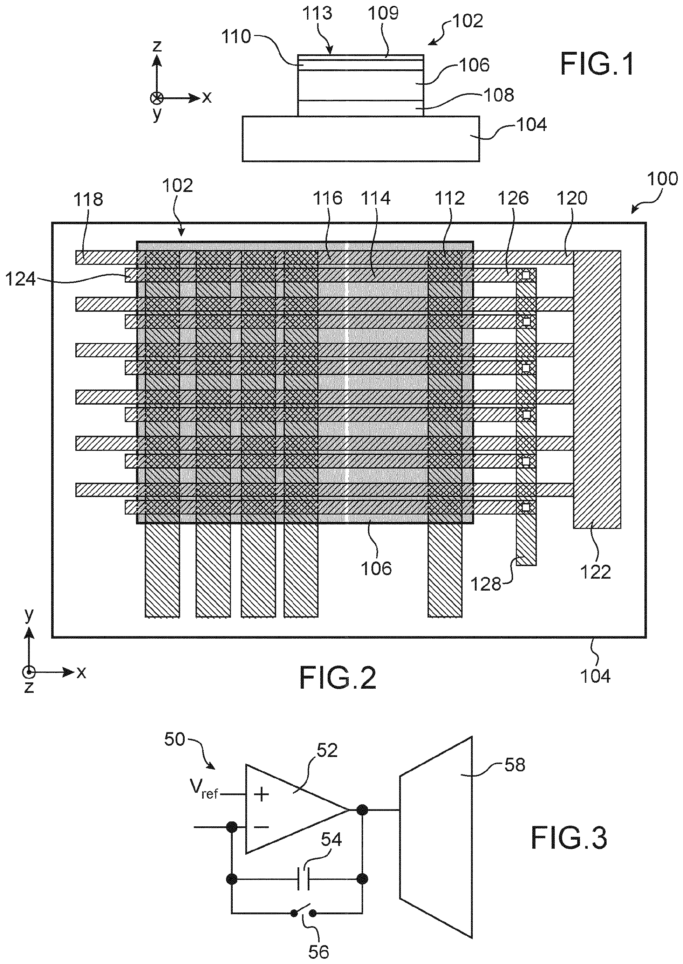

On se réfère tout d'abord à la figure 1 qui représente une vue en coupe d'une partie d'un pixel 102 d'un capteur 100 de motif thermique.

Le pixel 102 est réalisé sur un substrat 104 correspondant par exemple à un substrat de verre ou de semi-conducteur (par exemple du silicium). Le substrat 104 peut également être un substrat souple, par exemple à base de polyimide ou de PEN (polyéthylène naphtalate) ou de PET (polyéthylène téréphtalate), sur lequel les éléments électroniques du capteur 100, tels que des transistors TFT, sont réalisés par technologie électronique imprimée (par exemples via une réalisation avec des têtes d'écriture de type jet d'encre) ou par lithographie.

Les pixels 102 du capteur 100 sont disposés en formant une matrice de plusieurs lignes et plusieurs colonnes de pixels 102. Le pas des pixels 102, dans le plan (X,Y) (c'est-à-dire le plan du substrat 104), est par exemple compris entre environ 50 $\mu$m et 100 $\mu$m. Dans le cas d'un capteur 100 de résolution égale à 500 dpi (« dot per inch »), le pas des pixels 102 est égal à 50,8 $\mu$m.

Chacun des pixels 102 du capteur 100 comporte des moyens de mesure, ou de détection, thermique formés par une capacité pyroélectrique. Chaque capacité pyroélectrique comporte une portion 106 de matériau pyroélectrique disposée entre une électrode inférieure 108 et une électrode supérieure 110. Le matériau pyroélectrique de la portion 106 est avantageusement du P(VDF-TrFE) ou du PVDF. En variante, le matériau pyroélectrique de la portion 106 peut être de l'AIN ou du PZT, ou tout autre matériau pyroélectrique adapté pour former une capacité pyroélectrique. L'épaisseur de la portion 106 est par exemple comprise entre environ 500 nm et 10 $\mu$m.

Les électrodes 108, 110 comportent chacune au moins un matériau électriquement conducteur, par exemple un matériau métallique tel que du titane d'épaisseur égale à environ 0,2 $\mu$m, et/ou du molybdène et/ou de l'aluminium et/ou un oxyde conducteur tel que de l'ITO (oxyde d'indium et d'étain) et/ou un polymère conducteur. L'une des électrodes 108, 110, avantageusement l'électrode supérieure 110, ou chacune des deux électrodes 108, 110, peut être formée par un empilement de plusieurs matériaux électriquement conducteurs, par exemple un empilement Ti/TiN/AlCu. L'épaisseur de chacune des électrodes 108, 110 est par exemple comprise entre environ 0,1 $\mu$m et 1 $\mu$m. L'épaisseur de chacune des électrodes 108, 110 peut être plus importante, allant par exemple jusqu'à environ 5 $\mu$m, notamment lorsque ces électrodes sont réalisées par impression en utilisant des matériaux tels que l'argent, le cuivre, le carbone ou encore le PEDOT(poly(3,4-éthylènedioxythiophène).

Une couche de protection 109, correspondant par exemple à une couche de nitrure d'aluminium ou de tout autre matériau adapté à la réalisation de cette couche, recouvre l'électrode supérieure 110. L'épaisseur de la couche de protection 109 peut être comprise entre quelques microns et environ 100 $\mu$m, ou bien plus importante (par exemple de l'ordre de 300 $\mu$m ou plus). Une face supérieure 113 de la couche de protection 109 correspond à la surface au-dessus de laquelle se trouve le motif thermique destiné à être détecté, par exemple un doigt dont l'empreinte est destinée à être détectée.

Pour que le PVDF de la portion 106 acquière ses propriétés pyroélectriques (et aussi piézoélectriques), ce matériau est soumis, une fois pour toute la durée de vie de la capacité pyroélectrique, à un champ électrique d'environ 100 volts par micron d'épaisseur de PVDF. Les molécules à l'intérieur du PVDF s'orientent, et restent orientées ainsi, même lorsque le PVDF n'est plus soumis à ce champ électrique. Le PVDF peut être ainsi polarisé en appliquant une tension de polarisation initiale aux bornes des électrodes 108, 110.

Après cette polarisation initiale, lorsque la portion 106 est soumise à une variation de température $\Delta$T, cette variation de température $\Delta$T provoque l'apparition d'un champ électrique supplémentaire générant des charges $\Delta$Q entre les électrodes 108, 110 telles que :

$$\Delta Q = S.\gamma.\Delta T$$

Le paramètre S correspond à la surface de la portion 106 en regard avec chacune des électrodes 108, 110. Le paramètre $\gamma$ correspond au coefficient pyroélectrique du matériau pyroélectrique de la portion 106. Par exemple, le coefficient pyroélectrique $\gamma$ du PVFD-TrFE est égal à environ 32 $\mu$C/m$^2$/K.

La portion 106 et les électrodes 108, 110 formant une capacité de valeur C à laquelle s'ajoutent des capacités parasites Cp, les charges $\Delta$Q générées induisent une différence de potentiels électriques $\Delta$V entre les électrodes 108, 110 telle que :

$$\left(C + C_p\right)\Delta V = \Delta Q = S.\gamma.\Delta T$$

En plus des charges générées par la capacité de valeur C, d'autres charges parasites peuvent être générées également via les capacités parasites Cp présentes.

Lorsque le potentiel sur l'électrode de lecture (formée par l'une des électrodes 108, 110) est fixe (lecture dite « en courant »), les charges générées s'écoulent vers le circuit de lecture en formant un courant intégré en sortie, avec dans ce cas :

$$\frac{\Delta Q}{\zeta} = \frac{S.\gamma.\Delta T}{\zeta}$$

avec $\zeta$ correspondant au temps d'intégration pendant lequel la mesure est réalisée par le pixel. Une telle lecture en courant a pour avantage d'être insensible, au premier ordre, à la valeur des capacités, en particulier des capacités parasites.

Le sens du courant obtenu entre les électrodes 108, 110 dépend du sens du champ électrique avec lequel le PVDF de la portion 106 a été initialement polarisé. Dans le cas de certains autres matériaux pyroélectriques tels que le nitrure d'aluminium, ce sens de polarisation initiale dépend de la manière avec laquelle le matériau pyroélectrique a été déposé, de son ordre et de son orientation cristallographique. En outre, le sens du courant obtenu peut varier suivant que la variation de température subie par la capacité pyroélectrique soit positive ou négative.

Le capteur 100 comporte également des éléments chauffants dissipant une certaine quantité de chaleur dans les pixels 102, et notamment dans le matériau pyroélectrique. Ces éléments chauffants sont par exemple formés par des portions électriquement conductrices issues de la même couche que celle servant à la réalisation des électrodes supérieures 110 ou des électrodes inférieures 108. Sur l'exemple de la figure 1, l'élément chauffant n'est pas visible et est réalisé par une portion de la couche conductrice servant à la réalisation des électrodes supérieures 110 comme décrit plus loin en lien avec la figure 2.

Le chauffage de la portion 106 de matériau pyroélectrique est obtenu en faisant circuler un courant dans l'élément chauffant formant la résistance de chauffage de chacun des pixels 102.

La figure 2 représente une vue de dessus de plusieurs pixels 102 du capteur 100 selon un premier mode de réalisation.

Les électrodes inférieures, qui forment ici les électrodes de lecture des pixels 102 sur lesquelles les charges générées par les capacités pyroélectriques seront récupérées pour être lues, sont formées par des premières portions 112 de matériau électriquement conducteur. Les électrodes inférieures des pixels d'un même colonne sont reliées électriquement les unes aux autres du fait que ces électrodes inférieures des pixels d'une même colonne sont formées par une même première portion conductrice 112 qui s'étend sur toute la longueur de la colonne de pixels 102 et qui est en contact avec les portions 106 de matériau pyroélectrique de tous les pixels de la colonne. Chacune des portions 112 s'étend selon une direction parallèle aux colonnes de pixels 102, c'est-à-dire ici verticalement, parallèlement à l'axe Y. En outre, chacune des premières portions électriquement conductrices 112 est distincte des autres premières portions électriquement conductrices 112 formant les électrodes de lecture des pixels 102 des autres colonnes.

En pied de chacune des colonnes de pixels, chacune des premières portions conductrices 112 est reliée électriquement à un circuit de lecture (non visible sur la figure 2) commun à tous les pixels d'une même colonne.

Les portions 106 de matériau pyroélectrique de l'ensemble des pixels de la matrice du capteur 100 sont ici réalisées sous la forme d'une seule couche de matériau pyroélectrique recouvrant toutes les électrodes inférieures des pixels 102.

Les électrodes supérieures correspondent ici aux électrodes de polarisation des pixels 102 et sont formées par des portions 114 électriquement conductrices chacune commune à tous les pixels 102 d'une même ligne de pixels. Chacune des portions 114 s'étend par exemple selon une direction parallèle aux lignes de pixels 102, c'est-à-dire horizontalement sur la figure 2, parallèlement à l'axe X.

Ainsi, dans chaque pixel 102, une capacité pyroélectrique est formée par les parties des portions 112 et 114 qui sont superposées l'une au-dessus de l'autre ainsi que du matériau pyroélectrique se trouvant entre ces parties des portions 112 et 114. Cette surface de superposition des portions 112, 114 est donc représentative de la quantité de charges générées, et est de préférence la plus grande possible.

Les éléments chauffants des pixels 102 sont formés par des portions 116 électriquement conductrices chacune commune à tous les pixels 102 d'une même ligne de pixels, et qui sont distinctes des portions 114 formant les électrodes de polarisation des pixels. Chacune des portions 116 s'étend ici selon une direction sensiblement parallèle aux lignes de pixels 102, c'est-à-dire parallèlement à l'axe X sur la figure 2.

Les portions conductrices 114 et 116 sont avantageusement issues d'une même couche électriquement conductrice. Sur la figure 2, au sein d'une même ligne de pixels 102, les portions 114, 116 sont juxtaposées les unes à côté des autres, au-dessus de la couche de matériau pyroélectrique.

Sur l'exemple de la figure 2, la largeur (dimension selon l'axe X, c'est-à-dire la dimension se trouvant dans le plan des pixels 102 et qui est perpendiculaire à la direction selon laquelle s'étendent les colonnes de pixels 102) de chacune des premières portions conductrices 112 est constante sur toute leur longueur. Par exemple, en considérant des pixels de pas égal à environ 50 $\mu$m, la largeur de chacune des premières portions conductrices 112 peut être égale à environ 45 $\mu$m, ces premières portions conductrices 112 pouvant être espacées les unes des autres de 5 $\mu$m environ.

En variante, il est possible que la largeur de chacune des premières portions conductrices 112 ne soit pas constante sur toute leur longueur. La largeur des parties des premières portions conductrices 112 se trouvant en regard des portions 114, 116, c'est-à-dire au sein de chacun des pixels 102, peut être supérieure à celle des parties des premières portions conductrices 112 se trouvant entre les pixels 102.

Selon une autre variante, il est possible que la largeur des parties des premières portions électriquement conductrices 112 se trouvant en regard des portions 114 soit supérieure à celle des parties des premières portions électriquement conductrices 112 se trouvant entre les pixels 102 et en regard des portions 116. Cette autre variante a pour avantage de réduire les capacités parasites car dans ce cas.

En outre, seule la capacité formée par la superposition des portions 112 et 114 peut être polarisée, afin que la superposition des portions 112 et 116 ne génère pas de charges.

En outre, sur l'exemple de la figure 2, en considérant des pixels de pas égal à environ 50 $\mu$m, la largeur de chacune des portions 114, 116 est par exemple inférieure ou égale à environ 20 $\mu$m (en considérant un espacement d'environ 5 $\mu$m entre chacune de ces portions).

Chacune des portions 116 formant les éléments chauffants d'une ligne de pixels comporte deux extrémités 118, 120 sur lesquelles une tension de chauffage est destinée à être appliquée. L'une de ces deux extrémités 118, 120 est par exemple reliée à la masse, et un potentiel électrique de chauffage non nul est appliqué sur l'autre de ces deux extrémités 118, 120 par des moyens de chauffage par exemple formés par une liaison électrique appliquant une tension sur cette autre extrémité. Par exemple, si les extrémités 120 des portions 116 sont reliées à la masse et qu'un potentiel de chauffage $V_{chauffe}$ est appliqué sur l'extrémité 118 d'une des portions 116, comme c'est le cas sur la figure 2, un courant s'écoule alors depuis l'extrémité 118 jusqu'à l'extrémité 120 de cette portion 116, provoquant un échauffement par effet Joule dans cette portion 116, et échauffant ainsi le matériau pyroélectrique de tous les pixels 102 de la ligne de pixels qui est chauffée par cette portion 116.

Sur l'exemple de la figure 2, les extrémités 120 des portions 116 formant les éléments chauffants sont reliées à une autre portion conductrice 122 commune à toutes les portions 116 et qui est reliée à la masse du capteur 100.

Chacune des portions 114 comporte une première extrémité 124 sur laquelle un potentiel de polarisation est destiné à être appliqué et une deuxième extrémité 126 reliée à la masse du capteur 100. Sur l'exemple de la figure 2, les extrémités 126 des portions 114 sont reliées à une autre portion conductrice 128 commune à toutes les lignes de pixels et qui est reliée à la masse du capteur 100.

La valeur de la tension de chauffage appliquée sur les extrémités 118, 120 des portions 116 est choisie en fonction de la puissance de chauffage désirée, cette puissance étant fonction notamment de la résistivité du matériau des portions 116, de l'épaisseur de la portion de matériau pyroélectrique destinée à être chauffée ainsi que de l'épaisseur de la couche de protection 109, du coefficient pyroélectrique du matériau pyroélectrique, de la sensibilité du circuit de lecture, du niveau de bruit du circuit de lecture et du temps d'intégration. Dans un pixel 102, la puissance de chauffage est par exemple comprise entre environ 0,1 mW et 10 mW.

Dans le capteur 100, du fait que chaque portion 116 peut être adressée indépendamment des autres portions 116 associées aux autres lignes de pixels, il est donc possible de déclencher le chauffage de chacune des lignes de pixels indépendamment les unes des autres. De plus, du fait que les électrodes inférieures des pixels d'une même colonne sont reliées entre elles, les charges obtenues en pied de chacune des portions conductrices formant les électrodes inférieures 108 correspondent donc aux charges générées par les pixels appartenant à la ligne de pixels qui a été chauffée.

Ainsi, le capteur 100 ne fait appel à aucun transistor de sélection au sein des pixels 102 puisqu'en ayant relié les électrodes de lecture des pixels 102 d'une même colonne entre elles, l'adressage par ligne de pixels réalisé par les éléments chauffants est suffisant pour savoir à quels pixels correspondent les charges électriques reçues par les circuits de lecture se trouvant en pied de colonnes.

Un potentiel fixe est appliqué sur les portions 114, par exemple celui de la masse.

Un exemple de réalisation d'un circuit de lecture 50 auquel chacune des portions 112 (formant les électrodes de lecture des pixels 102) est reliée est représenté sur la figure 3.

L'entrée du circuit de lecture 50 à laquelle est reliée la portion 112 correspond à l'entrée inverseuse d'un amplificateur de lecture 52. Cet amplificateur de lecture 52 correspond ici à un amplificateur opérationnel. Un potentiel électrique de polarisation $V_{ref}$ est appliqué sur l'entrée non inverseuse de l'amplificateur 52. La sortie de l'amplificateur 52 est rebouclée sur son entrée inverseuse par l'intermédiaire d'une capacité 54. Un interrupteur 56, ou commutateur, est relié en parallèle à la capacité 54 et permet de court-circuiter la capacité 54. La sortie de l'amplificateur de lecture 52 est également reliée à l'entrée d'un convertisseur analogique/numérique 58. L'amplificateur de lecture 52, la capacité 54, l'interrupteur 56 et le convertisseur analogique/numérique 58 sont communs à tous les pixels 102 d'une même colonne. Le convertisseur analogique/numérique 58 peut être commun à toutes les colonnes de pixels 102 du capteur 100, moyennant l'ajout d'éléments électroniques de multiplexage entre les sorties des amplificateurs de lecture 52 associés aux différentes colonnes de pixels et le convertisseur analogique/numérique 58.

Les éléments électroniques formant les circuits de lecture 50 peuvent être réalisés sur un substrat différent de celui sur lequel les pixels 102 sont réalisés, ces substrats pouvant être assemblés ultérieurement l'un à l'autre. Ainsi, les éléments électroniques de ces circuits de lecture peuvent être réalisés avec une technologie de réalisation (par exemple CMOS) différente de celle servant à la réalisation des pixels 102 (par exemple par impression).

Dans ce premier mode de réalisation, les éléments chauffants se trouvent au même niveau que les électrodes de polarisation car les portions de matériau électriquement conducteur formant les éléments chauffants et celles formant les électrodes de polarisation sont issues d'une même couche de matériau électriquement conducteur. Toutefois, il est possible que les éléments chauffants soient disposés non pas directement sur le matériau pyroélectrique mais à côté ou au-dessus ou en-dessous des capacités pyroélectriques.

En variante, il est possible que la surface contre laquelle se trouve le motif thermique destiné à être détecté corresponde à la face arrière du substrat 104, c'est-à-dire la face opposée à celle sur laquelle repose l'électrode 108. Cette variante peut être avantageuse lorsque le critère principal recherché n'est pas la résolution du capteur 100. Dans ce cas, le substrat 104 forme une surface robuste sur laquelle le doigt vient en contact. De plus, les éléments chauffants peuvent dans ce cas être formés par les électrodes inférieures 108 réalisées comme précédemment décrit pour les électrodes supérieures 110. Enfin, cette variante permet de positionner les circuits de lecture à côté de la zone sensible du capteur 100 mais protégés car disposés du côté du substrat 104 opposé à celui où le doigt est destiné à être positionné.

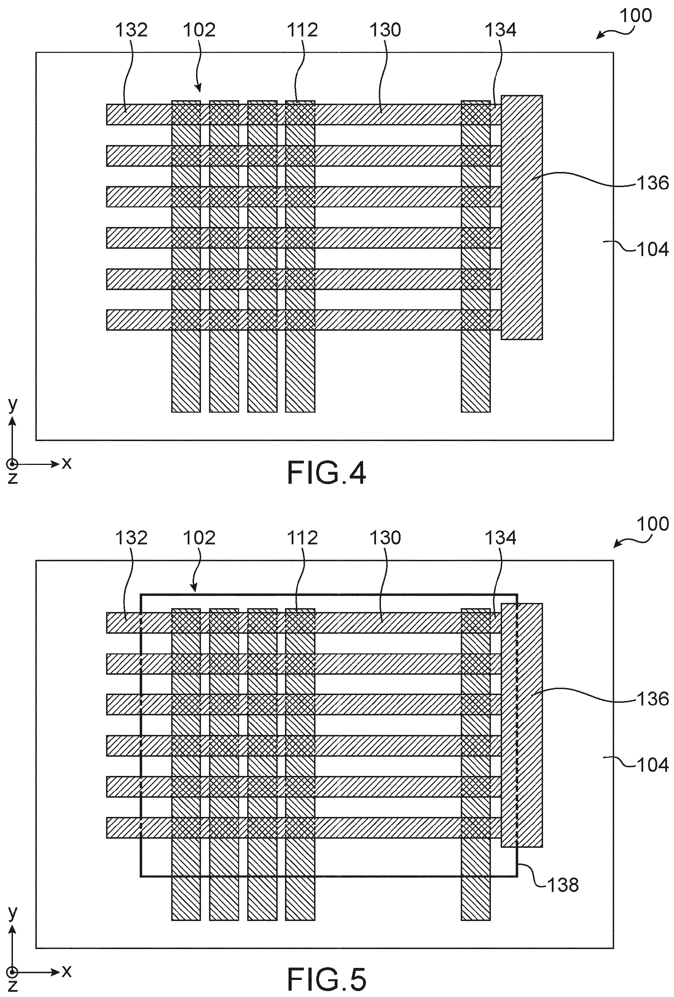

La figure 4 représente une vue de dessus de plusieurs pixels 102 du capteur 100 selon un deuxième mode de réalisation.

Contrairement au premier mode de réalisation dans lequel les électrodes de polarisation et les éléments chauffants sont formés par des portions distinctes de matériau électriquement conducteur disposées l'une à côté de l'autre, ces éléments sont ici formés par une seule deuxième portion de matériau électriquement conducteur pour chaque ligne de pixels 102. Sur la figure 4, des deuxièmes portions 130 électriquement conductrices s'étendent parallèlement à l'axe X telles que chacune des portions 130 forme à la fois les électrodes supérieures, correspondant aux électrodes de polarisation, et les éléments chauffants des pixels appartenant à une même ligne de pixels.

Chaque portion 130 comporte une première extrémité 132 sur laquelle un potentiel de chauffage est destiné à être appliqué, et une deuxième extrémité 134 reliée à un potentiel électrique de référence, ici à la masse, par l'intermédiaire d'une portion électriquement conductrice 136.

Dans le premier mode de réalisation précédemment décrit, la capacité pyroélectrique de chaque pixel 102 est formée uniquement par la partie du matériau pyroélectrique se trouvant entre l'électrode de lecture (formée par la portion 112) et l'électrode de polarisation (formée par la portion 114). Du fait que l'élément chauffant est formé à côté de l'électrode de polarisation, la partie du matériau pyroélectrique se trouvant entre l'élément chauffant et l'électrode de lecture ne fait pas partie de cette capacité pyroélectrique. Dans le premier mode de réalisation, l'élément chauffant ne chauffe donc pas directement la portion de matériau pyroélectrique de la capacité pyroélectrique de chaque pixel.

Dans le deuxième mode de réalisation représenté sur la figure 4, du fait que l'élément chauffant et l'électrode de polarisation de chaque pixel 102 sont formés par une même portion électriquement conductrice 130, toute la portion de matériau pyroélectrique se trouvant entre l'électrode de lecture et la partie de la portion 130 se trouvant en regard de l'électrode de lecture fait partie de la capacité pyroélectrique.

Le chauffage de la portion de matériau pyroélectrique est obtenu en faisant circuler un courant dans l'électrode destinée à former l'élément chauffant. Or, cette électrode sert également à la polarisation de la capacité pyroélectrique. Ainsi, la résistance de chauffage de chacun des pixels 102 sert donc également à la polarisation d'une des électrodes de la capacité pyroélectrique de chacun des pixels 102 lors de la mesure réalisée par ces pixels 102 (cette polarisation appliquée lors d'une mesure est différente de la polarisation initiale du PVDF précédemment décrite).

L'utilisation de l'une des électrodes supérieure et inférieure des pixels 102 pour former les éléments chauffants est possible du fait que la valeur du potentiel électrique appliqué sur cette électrode lors d'une lecture du motif thermique est constante pendant la lecture des charges.

Dans ce deuxième mode de réalisation, un seul signal est utilisé pour piloter les lignes de pixels 102 du capteur 100, c'est-à-dire réaliser à la fois la commande de chauffage et la sélection de ligne de pixels. Si un pixel n'est pas chauffé, il ne se passe rien, et lorsqu'un pixel est chauffé, un certain nombre de charges (nombre dépendant de l'élément présent sur le pixel, crête ou vallée dans le cas d'une empreinte digitale) sont générées. Ainsi, en ne réalisant le chauffage que d'une ligne de pixels à la fois puis en le lisant, le potentiel électrique de chauffage joue à la fois le rôle de chauffe et de pilotage/repérage d'une ligne de pixels.

Les valeurs des tensions de chauffage appliquées sur les portions 130 sont ajustées par rapport à la résistivité du métal des portions 130 afin de produire l'énergie thermique désirée dans les pixels 102.

En variante des premier et deuxième modes de réalisation précédemment décrits, il est possible que l'électrode supérieure et l'élément chauffant des pixels soient recouverts d'une couche diélectrique elle-même recouverte d'une première couche électriquement conductrice qui est reliée électriquement à la masse. Cette couche électriquement conductrice peut être recouverte par la couche de protection 109. Cette couche électriquement conductrice, comprenant par exemple une encre électriquement conductrice, forme ainsi un blindage électromagnétique entre l'élément dont le motif thermique est destiné à être détecté, par exemple un doigt dans le cas d'un capteur 100 d'empreinte digitale, et l'électrode de polarisation de chaque pixel, évitant ainsi la récupération de bruit électromagnétique (par exemple du bruit à 50 Hz provenant du secteur) dans les mesures réalisées. Cette couche électriquement conductrice permet également de protéger le capteur 100 vis-à-vis des décharges électrostatiques (ESD).

La figure 5 représente une vue de dessus de plusieurs pixels 102 du capteur 100 selon un troisième mode de réalisation.

Comme dans les précédents modes de réalisation, le capteur 100 comporte les portions 112 formant les électrodes de lecture des pixels qui sont reliées électriquement entre elles au sein de chacune des colonnes de pixels. De plus, comme dans les précédents modes de réalisation, une couche de matériau pyroélectrique, non visible sur la figure 4, est disposée sur les électrodes de lecture.

La couche de matériau pyroélectrique est recouverte par une couche électriquement conductrice 138, par exemple métallique, qui n'est pas structurée et qui recouvre l'ensemble de la couche de matériau pyroélectrique. Cette couche électriquement conductrice 138 est reliée à la masse. La couche électriquement conductrice 138 est recouverte d'une couche diélectrique sur laquelle les portions 130 formant les éléments chauffants des pixels sont disposées.

Par rapport à la précédente variante de réalisation dans laquelle une couche de blindage électromagnétique est disposée au-dessus des capacités pyroélectriques, le capteur selon ce troisième mode de réalisation intègre cette couche de blindage électromagnétique directement au-dessus du matériau pyroélectrique en se servant de la couche conductrice formant les électrodes supérieures des capacités pyroélectriques des pixels. Dans cette configuration, peu de courant traverse les électrodes supérieures et inférieures des pixels. Ainsi, ces électrodes peuvent être avantageusement réalisées par dépôt d'une encre électriquement conductrice, facilitant ainsi la réalisation du capteur 100.

Afin de pouvoir lire les pixels de chaque ligne de la matrice, les éléments chauffants de chaque ligne de pixels sont soumis à un échauffement pour une seule ligne de pixels à la fois afin de ne pas avoir, en pied de chaque colonne, la réponse de deux pixels additionnés. Pendant le chauffage d'une ligne de pixels, chaque pixel de la ligne chauffée génère des charges, qui se répartissent sur toute la colonne de pixel. En bas de colonne, les charges générées sont lues.

La lecture d'une ligne de pixels est décrite de manière plus détaillée ci-dessous.

Les circuits de lecture sont tout d'abord réinitialisés. Dans le cas de circuits de lecture tels que celui précédemment décrit en liaison avec la figure 3, cette réinitialisation est obtenue en fermant les interrupteurs 56. Le potentiel électrique des portions 112 est à la valeur $V_{ref}$. Le chauffage des pixels d'une des lignes de la matrice est ensuite initié en appliquant une tension de chauffage entre les extrémités de la portion conductrice formant les éléments chauffants de la ligne de pixels. Les capacités pyroélectriques des pixels de cette ligne se trouvent à ce moment à une température $T_0$.

Les interrupteurs 56 sont ensuite ouverts. L'intégration débute alors au niveau des capacités pyroélectriques des pixels 102 de la ligne, pendant un temps d'intégration $\zeta$ par exemple égal à environ 500 $\mu$s. Des charges électriques sont générées par les capacités pyroélectriques des pixels 102 de la ligne pendant ce temps d'intégration $\zeta$. Du fait que les interrupteurs 56 sont ouverts, les charges électriques générées par les capacités pyroélectriques des pixels 102 de la ligne s'écoulent vers les capacités 54.

A l'issu de ce temps d'intégration $\zeta$, les capacités pyroélectriques se trouvent à une température $T_1$ (différente d'un pixel à l'autre) et ont donc été soumises à une variation de température $\Delta T = T_1 - T_0$, les charges électriques générées par les capacités pyroélectriques et stockées dans les capacités 54 étant la conséquence de cette variation de température. Les potentiels électriques en sortie des amplificateurs 52 est donc $V_{out} = Q.C_{ref} + V_{ref}$, avec Q correspondant aux charges électriques générées et $C_{ref}$ la valeur de la capacité 54. Ce potentiel est alors lu et échantillonné par le convertisseur analogique/numérique 58. Le chauffage de la ligne de pixels est ensuite stoppé. Lorsque l'opération de lecture et d'échantillonnage du résultat est achevée, l'interrupteur 56 est commuté en position fermée pour décharger la capacité 54.

Lors d'une telle lecture, le potentiel électrique $V_{chauffe}$ appliqué sur l'une des électrodes de la capacité pyroélectrique (sur l'extrémité 118 pour le capteur 100 selon le premier mode de réalisation ou sur l'extrémité 132 pour le capteur 100 selon les deuxième et troisième modes de réalisation) est constant tout au long de la lecture d'un pixel. Par contre, du fait que la portion de matériau conducteur sur laquelle est appliqué ce potentiel est commune à tous les pixels 102 de la ligne de pixels associée à cette portion, la valeur du potentiel de chauffage appliqué sur les capacités pyroélectriques de chacun de ces pixels 102 est différente d'un pixel à l'autre.

En considérant par exemple le deuxième mode de réalisation représenté sur la figure 4, l'électrode supérieure de la capacité pyroélectrique la plus proche de l'extrémité 132 est soumise à un potentiel sensiblement égal à $V_{chauffe}$. L'électrode supérieure de la capacité pyroélectrique suivante est soumise à un potentiel électrique sensiblement égal à $V_{chauffe} - \delta V$. Les valeurs des potentiels électriques appliqués sur les électrodes supérieures des capacités pyroélectriques diminuent proportionnellement à leur éloignement vis-à-vis de l'extrémité 132. Lorsque la portion conductrice 136 est reliée à la masse, l'électrode supérieure de la dernière capacité pyroélectrique, correspondant à celle qui est la plus proche de l'extrémité 134, est soumise à un potentiel électrique sensiblement égal à 0 V, c'est-à-dire le potentiel électrique de la masse. Cette variation du potentiel électrique de chauffage appliqué d'un pixel à l'autre ne modifie pas le chauffage réalisé d'un pixel à l'autre du fait que l'écoulement du courant dans la portion conductrice 130 provoquant l'échauffement est le même dans toute la deuxième portion conductrice 130 et le même pour tous les pixels 102 de la ligne car les résistances de chauffage de tous ces pixels 102 sont identiques.

A la lecture d'une ligne de pixels, les valeurs des potentiels sur les électrodes de polarisation de chaque pixel sont différentes d'un pixel à l'autre. Par contre, pour une même variation de température, la différence de tensions, ou la différence de nombre de charges, générée aux bornes des capacités pyroélectriques des pixels est identique. Or, ce sont les charges excédentaires générées par rapport à la tension de référence qui sont lues, qu'elles soient positives ou négatives. Par exemple, dans le cas de l'exemple de réalisation représenté sur la figure 3, la tension de lecture résultante obtenue en sortie de l'amplificateur 52 est $V_{out} = V_{ref} \pm \Delta Q/Cf$, avec Cf correspondant à la valeur de la capacité 54, qui est indépendante de la tension aux bornes des capacités pyroélectriques lorsque le potentiel $V_{chauffe}$ est stable durant le temps d'intégration.

Dans l'exemple de réalisation précédemment décrit en liaison avec la figure 3, les charges électriques générées sont lues directement par l'amplificateur 52.

La puce comportant les circuits de lecture 50 est avantageusement réalisée à partir d'un substrat de silicium, et reportée sur un autre circuit sur lequel les pixels 102 sont réalisés.

Du fait que les électrodes de lecture des pixels d'une même colonne soient formées par une seule portion conductrice, et donc que toutes ces électrodes de lecture soient reliées au circuit de lecture pendant la lecture d'un pixel, un temps de refroidissement est de préférence respecté après avoir lu une ligne de pixels avant de lire la ligne de pixels suivante pour ne pas prendre en compte les charges négatives générées en grande quantité au début du refroidissement. La durée de ce refroidissement est par exemple comprise entre environ 2 et 5 fois le temps de chauffe. Ainsi, une ligne de pixels du capteur 100 peut être lue et refroidie en environ 2 ms, ce qui permet une lecture d'environ 500 lignes de pixels par seconde.

Le circuit de lecture a un signal à bruit dépendant de la valeur de la capacité formée par les pixels reliés à ce circuit de lecture. Plus la capacité est élevée, plus le bruit obtenu est élevé. Un compromis est donc réalisé entre le nombre lignes de pixels du capteur (plus le capteur à un nombre de lignes de pixels important, plus un grand nombre de pixels est relié à chaque circuit de lecture, et plus le bruit reçu par les circuits de lecture est important) et le bruit tolérable pour que la mesure reste correcte. Ce rapport signal à bruit peut également être augmenté en augmentant la puissance de chauffage des pixels.

Dans le cas d'un capteur 100 comportant 300 lignes de pixels, la capacité totale sur une colonne correspond à la somme des capacités pyroélectriques de 300 pixels. Avec une capacité pyroélectrique d'épaisseur égale à environ 1 $\mu$m (épaisseur de matériau pyroélectrique), la capacité par colonne de pixels est d'environ 100 fF x 300 = 30 pF. Ainsi, le capteur 100 comporte avantageusement entre environ 100 et 300 lignes de pixels.

Le tableau ci-dessous donne des résultats obtenus avec le capteur 100 selon le deuxième mode de réalisation pour différents pas de pixels (le pas étant la distance entre les centres de deux pixels voisins).

| Pas pixel (μm) | Dimensions capacité pyroélectrique (μm²) | ΔT requis pour générer | | | Capacité pyroélectrique |
|---|---|---|---|---|---|
| | | 10000 e- | 60000 e-(4 bits) | 1000000 e-(8 bits) | |
| 50 | 40 x 40 | 34 mK | 204 mK | 3400 mK | 100 fF |
| 100 | 90 x 90 | 6,8 mK | 41 mK | 380 mK | 500 fF |

Dans le tableau ci-dessus, les valeurs de la capacité pyroélectrique sont obtenues en considérant une épaisseur de matériau pyroélectrique égale à 1 μm.

Ainsi, pour des pixels de dimensions égales à 50 μm x 50 μm, un signal d'amplitude suffisante est obtenu lorsque les pixels sont soumis à une variation de température d'au moins environ 1K à 2K. Avec une couche de protection 109 d'épaisseur de l'ordre de 2 μm, des injections de puissance par pixel d'environ 0,2 mW permettent d'avoir un signal de sortie suffisamment puissant. L'injection de chaleur peut être adaptée pour obtenir une variation d'au moins un degré dans un pixel lu.

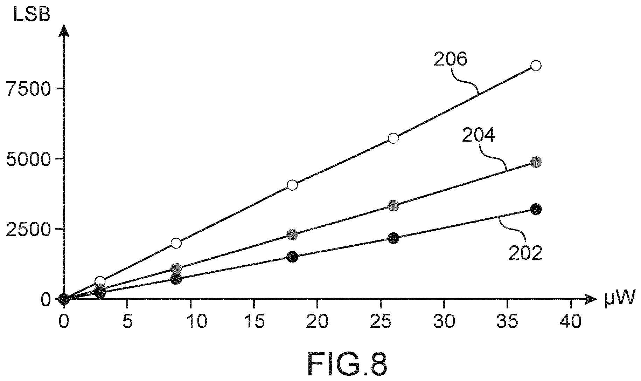

Les courbes 202, 204 et 206 de la figure 8 représentent le nombre de LSB (« Low Significant Bits », ou bits de poids faible) lus sur le convertisseur analogique/numérique 58 de 16 bits (ici de type AFE1256 commercialisé par Texas Instrument), soit un maximum de 65536 codes, en fonction de la puissance injectée par pixel (en μW), pour différents temps d'intégration (courbe 202 : $\zeta = 250$ μs ; courbe 204 : $\zeta = 500$ μs ; courbe 206 : $\zeta = 1600$ μs). Ces courbes représentent le nombre de bits obtenus entre un pixel en contact avec de l'air (vallée d'une empreinte) et un pixel en contact avec de l'eau (crête d'une empreinte). Ce nombre de bits est mesuré par exemple en disposant une goutte d'eau sur le capteur et en mesurant la différence entre chaque côté du bord de la goutte. Ces résultats représentent également le contraste maximum pouvant être obtenu. Ce contraste dépend linéairement de la puissance injectée ainsi que du temps d'intégration. La valeur de ce contraste dépend aussi de l'épaisseur de la couche de protection 109.

Dans les deuxième et troisième modes de réalisation représentés sur les figures 4 et 5, les portions 130 forment des bandes conductrices de largeur (dimension selon l'axe Y) uniforme s'étendant le long d'une ligne de pixels 102. La chaleur est ainsi diffusée de manière uniforme le long de chaque bande conductrice.

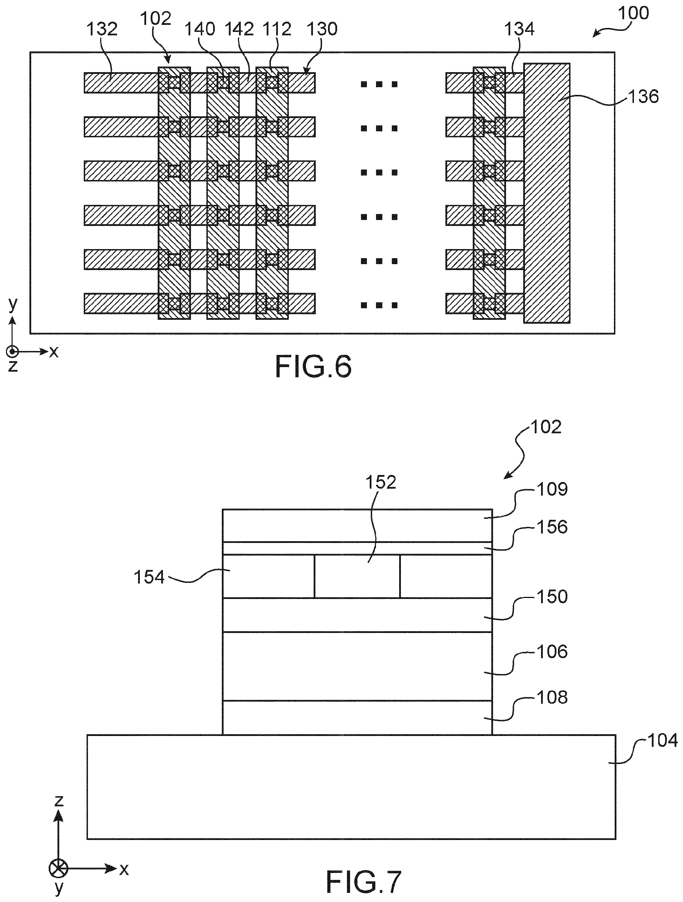

Selon une variante de réalisation représentée sur la figure 6 pouvant s'appliquer aux deuxième et troisième modes de réalisation, la largeur de chacune des portions 130 n'est pas uniforme sur toute sa longueur. Des parties 140 de chaque portion 130 localisées en regard des parties centrales des portions 112 de chaque pixel 102, c'est-à-dire centrées sur chaque pixel 102, ont une largeur inférieure à celle d'autres parties 142 disposées à cheval au-dessus de deux pixels et chacune reliant deux parties 140. Cette variante de réalisation permet de concentrer le chauffage réalisé sur chaque pixel 102 et limiter les déperditions de chaleur entre les pixels 102 du fait que la résistance électrique augmente à la jonction entre une partie 140 et une partie 142 adjacentes (ces jonctions étant localisées sur les pixels 102 et non entre les pixels 102), ce qui provoque un effet Joule plus important et une injection de chaleur plus importante au niveau de ces jonctions. Le fait d'avoir des points chauds centrés sur les pixels 102 réduit également les problèmes de diathermie, c'est-à-dire le transfert latéral de chaleur entre des pixels voisins. Cette variante entraîne toutefois une légère réduction des charges pyroélectriques générées du fait de la réduction de surface du matériau pyroélectrique en regard des portions 130, ce qui signifie qu'un compromis doit être trouvé entre les différents paramètres thermiques, les vitesses de lecture, etc.

Ces points chauds centrés sur les pixels 102 peuvent être réalisés non pas en réduisant la largeur de chacune des portions 130 au niveau des pixels 102, mais en réduisant l'épaisseur de matériau conducteur des portions 130 au niveau des pixels 102.

En variante des modes de réalisation précédemment décrits, il est possible que les portions 112 des différentes colonnes de pixels 102 puissent être initialement (c'est-à-dire au cours de la réalisation du capteur 100) reliées électriquement ensemble afin que la tension de polarisation initiale du matériau pyroélectrique puisse être appliquée sur chaque portion 112 à partir d'un unique point d'accès. Ensuite, lors de la singularisation des capteurs (lors de la découpe du wafer à partir duquel plusieurs capteurs sont réalisés), la ligne conductrice reliant les portions 112 est supprimée, isolant ainsi électriquement les portions 112 les unes des autres au sein de chaque capteur.

Dans l'exemple de lecture des lignes de pixels précédemment décrit, les éléments chauffants de chaque ligne de pixels sont allumés et éteints successivement, avec une phase de refroidissement entre chaque déclenchement du chauffage d'une des lignes de pixels.

En variante, il est possible que lors de la lecture de chaque ligne de pixels, outre le chauffage réalisé par les éléments chauffants associés à cette ligne de pixels, les éléments chauffants associés à une ou plusieurs précédentes lignes de pixels soient également allumés. Cela est possible car les mesures réalisées pour ces précédentes lignes de pixels peuvent être utilisées pour retrouver les valeurs de la ligne de pixels lue. Par exemple, pour la lecture de la première ligne de pixels 102, seuls les éléments chauffants de cette première ligne de pixels sont allumés. Après extinction de ces éléments chauffants et attente d'un refroidissement de la première ligne de pixels, la lecture de la deuxième ligne de pixels peut être réalisée en déclenchant les éléments chauffants associés à la deuxième ligne de pixels mais également les éléments chauffants de la première ligne de pixels. Les valeurs délivrées par la deuxième ligne de pixels peuvent être retrouvées en utilisant les résultats de mesure obtenus lorsque les éléments chauffants des deux lignes de pixels sont allumés, ainsi que les précédents résultats de mesure obtenus lors du chauffage de la première ligne de pixels. Ainsi, les mesures sont obtenues à partir de combinaisons linéaires faisant appel aux mesures des lignes de pixels précédemment lues.

Selon cette variante de lecture des pixels où les éléments chauffants de plusieurs lignes de pixels sont simultanément activés, il est possible de chauffer successivement plusieurs lignes de pixels sans attendre de refroidissement avant le chauffage d'une ligne de pixels suivante. Ainsi, il est par exemple possible de chauffer la première ligne de pixels, puis une autre ligne de pixels sans attendre de refroidissement de la première ligne de pixels, etc. Les différentes lignes de pixels chauffées successivement sont avantageusement disposées non immédiatement l'une à côté de l'autre afin de limiter la diathermie entre les différentes lignes de pixels. Par exemple, il est possible de chauffer la première ligne de pixels, puis la cinquième ligne de pixels, etc. Cette variante est avantageuse lorsque le capteur 100 comporte un nombre limité de lignes de pixels, par exemple moins de 10 lignes de pixels. De plus, dans cette variante, la lecture des charges est réalisée au moment où les pixels lus atteignent un quasi équilibre thermique, par exemple environ 90 % de l'équilibre thermique des pixels.

En outre, il est également possible que les puissances de chauffage appliquées pour les différentes lignes de pixels ne soient pas toutes similaires. Par exemple, lors d'une lecture sans refroidissement entre les lectures des différentes lignes de pixels et pour limiter l'impact des charges générées lors du refroidissement des lignes de pixels précédemment lues, il est possible d'augmenter, à chaque nouvelle ligne de pixels lue, la puissance avec laquelle la ligne de pixels lue est chauffée par rapport à la puissance avec laquelle la ligne de pixels précédente a été chauffée.

Enfin, il est également possible de ne pas réaliser de réinitialisation des circuits de lecture à la lecture de chaque ligne de pixels.

Dans tous les modes de réalisation, les effets de la diathermie se produisant entre des pixels voisins peuvent être compensés en appliquant des traitements numériques sur les mesures réalisées, par exemple de type filtre de Wiener. De plus, pour réduire ces effets du phénomène de diathermie, les lignes de pixels sont chauffées de préférence telles que deux lignes de pixels adjacentes ne soient pas chauffées immédiatement l'une après l'autre. Par exemple, en considérant un capteur 100 comprenant 8 lignes de pixels numérotées successivement de 1 à 8 (la ligne 1 se trouvant en haut du capteur 100 et la ligne 8 se trouvant en bas du capteur 100), il est possible de chauffer et lire les lignes de pixels dans l'ordre suivant : 1, 3, 5, 7, 2, 4, 6 et 8. Dans ce cas, la ligne de pixels chauffée est espacée d'un pixel par rapport à la ligne de pixels précédemment chauffée (sauf pour le chauffage de la ligne 2 dont les pixels sont éloignés de 4 pixels par rapport à la ligne 7). Ainsi, les températures initiales des pixels lus sont sensiblement plus égales les unes des autres que si les pixels lus subissent un chauffage dû à la diathermie et qui n'est pas assez refroidi avant la lecture. Il est également possible que la ligne de pixels chauffée soit espacée de plus d'un pixel par rapport à la ligne de pixels précédemment chauffée, par exemple espacée de deux ou trois pixels, voire plus dans le cas d'un capteur 100 comportant un plus grand nombre de lignes de pixels.

Dans les modes de réalisation précédemment décrits, les éléments chauffants sont formés par des portions d'une couche électriquement conductrice dans lesquelles le courant circule dans le plan de cette couche. En variante, il est possible que les éléments chauffants soient formés par plusieurs couches et/ou portions électriquement conductrices superposées, comme représenté schématiquement sur la figure 7. Sur cette figure, l'élément chauffant du pixel 102 est formé par une première portion conductrice 150 formant l'électrode supérieure du pixel 102, un élément résistif 152 disposé sur la première portion conductrice 150 et au sein d'une couche diélectrique 154, et une deuxième portion conductrice 156 disposée sur la couche diélectrique 154 et l'élément 152. Le courant de chauffage est amené depuis la couche 150, traverse l'élément 152 en produisant de la chaleur et est acheminé à la masse à travers la deuxième portion 156 (qui est reliée à la masse). Une telle variante a pour avantage de dissocier la localisation de l'élément chauffant vis-à-vis de celle de l'électrode supérieure, tout en conservant les avantages apportés par la mise en commun de la fonction de chauffage et la fonction de polarisation des pixels au sein d'un même élément électriquement conducteur. Il est ainsi possible de bien centrer l'élément 152 au milieu du pixel 102 afin de concentrer le plus possible la chaleur générée dans le pixel 102.

En variante des modes de réalisation précédemment décrits, les portions conductrices servant à la fois à la polarisation des capacités pyroélectriques et au chauffage du matériau pyroélectrique des pixels 102 peuvent correspondre non pas à celles formant les électrodes supérieures 110 des pixels 102 mais celles formant les électrodes inférieures 108 des pixels 102. De plus, des formes, ou designs, de la ou des portions conductrices qui forment les électrodes de la capacité pyroélectrique de chaque pixel 102 et les éléments de chauffage de ces pixels 102 autres que celles précédemment décrites peuvent être envisagées.

Bien que non représenté, le capteur 100 comporte un circuit de commande permettant d'appliquer les signaux de commande décrits ci-dessus pour piloter la lecture des pixels 102 via l'envoi de signaux dans les éléments de chauffage pour déclencher la mise en route du chauffage des pixels souhaités.

Le motif thermique détecté par le capteur 100 correspond avantageusement à une empreinte digitale, mais peut correspondre à tout motif ayant une capacité thermique et une chaleur massique.

Bien que non représenté, le capteur 100 peut comporter en outre un circuit électronique de traitement apte à construire une image globale du motif thermique à partir des mesures réalisées au niveau de chacun des pixels 102. Ce circuit électronique de traitement peut également être apte à comparer cette image à plusieurs images stockées dans une base de données afin d'identifier si le motif thermique détecté correspond à l'un de ceux stockés dans la base de données. Le circuit électronique de traitement peut également être apte à afficher une image du motif thermique détecté.

En outre, le capteur 100 comporte avantageusement, en plus des éléments de détection thermique précédemment décrits, des éléments de détection optique ou capacitive permettant de détecter une image de l'élément dont le motif thermique est également détecté. Ainsi, le capteur 100 peut comporter une matrice de pixels de détection optique entrelacée avec les pixels de détection thermique.

## Revendications

1. Capteur (100) de motif thermique comportant une matrice de plusieurs lignes et colonnes de pixels (102), chaque pixel (102) comprenant au moins :

   - une capacité pyroélectrique formée par au moins une portion de matériau pyroélectrique (106) disposée entre une électrode inférieure (108, 112) et une électrode supérieure (110, 114, 130, 145), dans laquelle une première des électrodes inférieure (108, 112) et supérieure (110, 114, 130, 145) correspond à une électrode de lecture du pixel (102), et
   - un élément chauffant (116, 130, 145) apte à chauffer la portion de matériau pyroélectrique (106) de la capacité pyroélectrique dudit pixel (102) lors d'une mesure du motif thermique par la capacité pyroélectrique dudit pixel (102),

   et dans lequel :

   - pour chaque ligne de pixels (102), les éléments chauffants (116, 130, 145) des pixels (102) de ladite ligne sont aptes à chauffer les portions de matériau pyroélectrique (106) des pixels (102) de ladite ligne indépendamment des éléments chauffants (116, 130, 145) des pixels (102) des autres lignes, réalisant ainsi une sélection de ladite ligne de pixels (102) pour une mesure du motif thermique par les capacités pyroélectriques des pixels (102) de ladite ligne, et

   le capteur étant **caractérisé en ce que** :

   - pour chaque colonne de pixels (102), les électrodes de lecture de chaque pixel (102) de ladite colonne sont reliées électriquement entre elles et formées par une même première portion électriquement conductrice (112) qui s'étend sur toute la longueur de la colonne de pixels (102) et qui est en contact avec les portions de matériau pyroélectrique (106) des pixels (102) de ladite colonne et distincte des premières portions électriquement conductrices (112) formant les électrodes de lecture des pixels (102) des autres colonnes, réalisant une lecture en colonnes de variations de charges générées dans une ligne de pixels (102) lors d'une mesure du motif thermique par les capacités pyroélectriques des pixels (102) de ladite ligne.

2. Capteur (100) de motif thermique selon la revendication 1, dans lequel :

   - dans chaque pixel (102), une deuxième des électrodes inférieure et supérieure correspond à une électrode de polarisation (114) du pixel (102) distincte des éléments chauffants (116), et
   - dans chaque ligne de pixels (102), les éléments chauffants (116) et les électrodes de polarisation (114) des pixels (102) de ladite ligne sont juxtaposés et disposés sur ou sous les portions de matériau pyroélectrique (106) des pixels (102) de ladite ligne.

3. Capteur (100) de motif thermique selon la revendication 1, dans lequel, dans chaque ligne de pixels (102), au moins une deuxième portion électriquement conductrice (130) forme à la fois l'élément chauffant et une deuxième des électrodes inférieure et supérieure de chacun des pixels (102) de ladite ligne.

**4.** Capteur (100) de motif thermique selon l'une des revendications précédentes, comportant en outre une couche diélectrique recouvrant l'électrode supérieure de chaque pixel (102) de la matrice et une première couche électriquement conductrice disposée sur ladite couche diélectrique.

**5.** Capteur (100) de motif thermique selon la revendication 1, dans lequel :

- une deuxième des électrodes inférieure et supérieure de chaque pixel (102) est formée par une deuxième couche électriquement conductrice (138) commune à tous les pixels (102) de la matrice et apte à être reliée électriquement à un potentiel électrique de référence, et
- dans chaque ligne de pixels (102), au moins une deuxième portion électriquement conductrice (130) forme les éléments chauffants des pixels (102).

**6.** Capteur (100) de motif thermique selon la revendication 5, dans lequel la deuxième couche électriquement conductrice (138) est disposée entre les éléments chauffants (130) et les électrodes de lecture (112).

**7.** Capteur (100) de motif thermique selon l'une des revendications 3, 5 et 6, dans lequel chaque deuxième portion électriquement conductrice (130) comporte, dans chaque pixel (102), des parties dont la résistance électrique est supérieure à celle du reste de ladite deuxième portion électriquement conductrice (130).

**8.** Capteur (100) de motif thermique selon l'une des revendications précédentes, dans lequel, pour chaque ligne de pixels (102), les éléments chauffants (116, 130) de chaque pixel (102) de ladite ligne sont reliés électriquement entre eux et formés par au moins une deuxième portion électriquement conductrice (116, 130) distincte des éléments chauffants des autres lignes de pixels (102) et apte à chauffer simultanément toutes les portions de matériau pyroélectrique (106) des pixels (102) de ladite ligne.

**9.** Capteur (100) de motif thermique selon l'une des revendications précédentes, dans lequel les électrodes de lecture correspondent aux électrodes inférieures des pixels (102).

**10.** Capteur (100) de motif thermique selon l'une des revendications 1 à 8, dans lequel les électrodes de lecture correspondent aux électrodes supérieures des pixels (102).

**11.** Capteur (100) de motif thermique selon l'une des revendications précédentes, dans lequel chacun des éléments chauffants comporte plusieurs portions électriquement conductrices superposées (150, 152, 156).

**12.** Procédé de réalisation d'un capteur (100) de motif thermique comportant une matrice de plusieurs lignes et colonnes de pixels (102), comprenant au moins la mise en œuvre des étapes suivantes :

- réalisation, pour chaque pixel (102), d'une capacité pyroélectrique formée par au moins une portion de matériau pyroélectrique (106) disposée entre une électrode inférieure (108, 112) et une électrode supérieure (110, 114, 130, 145), dans lequel une première des électrodes inférieure (108, 112) et supérieure (110, 114, 130, 145) correspond à une électrode de lecture du pixel (102), et
- réalisation d'un élément chauffant (116, 130, 145) apte à chauffer la portion de matériau pyroélectrique (106) de la capacité pyroélectrique dudit pixel (102) lors d'une mesure du motif thermique par la capacité pyroélectrique dudit pixel (102),

et dans lequel :

- pour chaque ligne de pixels (102), les éléments chauffants (116, 130, 145) des pixels (102) de ladite ligne sont aptes à chauffer les portions de matériau pyroélectrique (106) des pixels (102) de ladite ligne indépendamment des éléments chauffants (116, 130, 145) des pixels (102) des autres lignes, réalisant ainsi une sélection de ladite ligne de pixels (102) pour une mesure du motif thermique par les capacités pyroélectriques des pixels (102) de ladite ligne, et

le procédé étant **caractérisé en ce que** :

- pour chaque colonne de pixels (102), les électrodes de lecture de chaque pixel (102) de ladite colonne sont reliées électriquement entre elles et formées par une même première portion électriquement conductrice (112) qui s'étend sur toute la longueur de la colonne de pixels (102) et qui est en contact avec les portions de matériau pyroélectrique (106) des pixels (102) de ladite colonne et distincte des premières portions électriquement conductrices (112) formant les électrodes de lecture des pixels (102) des autres colonnes, réalisant une lecture en colonnes de variations de charges générées dans une ligne de pixels (102) lors d'une mesure du motif thermique par les capacités pyroélectriques des pixels (102) de ladite ligne.

**13.** Procédé selon la revendication 12, dans lequel la réalisation des électrodes inférieures (108) des pixels (102) et/ou des électrodes supérieures (110) des pixels (102) et/ou des éléments chauffants (116, 130, 145) des pixels (102) comporte la mise en œuvre d'au moins un dépôt par impression d'au moins un matériau électriquement conducteur.

## Patentansprüche

**1.** Wärmemuster-Sensor (100), umfassend eine Matrix aus mehreren Zeilen und Spalten von Pixeln (102), wobei jedes Pixel (102) mindestens umfasst: eine pyroelektrische Kapazität, die durch mindestens einen Abschnitt aus pyroelektrischem Material (106) gebildet ist, der zwischen einer unteren Elektrode (108, 112) und einer oberen Elektrode (110, 114, 130, 145) angeordnet ist, wobei eine erste der unteren (108, 112) und oberen (110, 114, 130, 145) Elektroden einer Ausleseelektrode des Pixels (102) entspricht, und ein Heizelement (116, 130, 145), das dazu eingerichtet ist, den Abschnitt aus pyroelektrischem Material (106) der pyroelektrischen Kapazität des besagten Pixels (102) während einer Messung des Wärmemusters durch die pyroelektrische Kapazität des besagten Pixels (102) zu erwärmen, und wobei: für jede Zeile von Pixeln (102) die Heizelemente (116, 130, 145) der Pixel (102) der besagten Zeile dazu eingerichtet sind, die Abschnitte aus pyroelektrischem Material (106) der Pixel (102) der besagten Zeile unabhängig von den Heizelementen (116, 130, 145) der Pixel (102) der anderen Zeilen zu erwärmen, wodurch eine Auswahl der besagten Zeile von Pixeln (102) für eine Messung des Wärmemusters durch die pyroelektrischen Kapazitäten der Pixel (102) der besagten Zeile realisiert wird, und wobei der Sensor **dadurch gekennzeichnet ist, dass**: für jede Spalte von Pixeln (102) die Ausleseelektroden jedes Pixels (102) der besagten Spalte elektrisch miteinander verbunden sind und durch einen selben ersten elektrisch leitenden Abschnitt (112) gebildet werden, der sich über die gesamte Länge der Spalte von Pixeln (102) erstreckt und der in Kontakt mit den Abschnitten aus pyroelektrischem Material (106) der Pixel (102) der besagten Spalte steht und von den ersten elektrisch leitenden Abschnitten (112), welche die Ausleseelektroden der Pixel (102) der anderen Spalten bilden, verschieden ist, wodurch ein spaltenweises Auslesen von Ladungsänderungen realisiert wird, die in einer Zeile von Pixeln (102) während einer Messung des Wärmemusters durch die pyroelektrischen Kapazitäten der Pixel (102) der besagten Zeile erzeugt werden.

**2.** Wärmemuster-Sensor (100) nach Anspruch 1, wobei: in jedem Pixel (102) eine zweite der unteren und oberen Elektroden einer Polarisationselektrode (114) des Pixels (102) entspricht, die von den Heizelementen (116) verschieden ist, und in jeder Zeile von Pixeln (102) die Heizelemente (116) und die Polarisationselektroden (114) der Pixel (102) der besagten Zeile nebeneinander angeordnet sind und auf oder unter den Abschnitten aus pyroelektrischem Material (106) der Pixel (102) der besagten Zeile angeordnet sind.

**3.** Wärmemuster-Sensor (100) nach Anspruch 1, wobei in jeder Zeile von Pixeln (102) mindestens ein zweiter elektrisch leitender Abschnitt (130) gleichzeitig das Heizelement und eine zweite der unteren und oberen Elektroden jedes der Pixel (102) der besagten Zeile bildet.

**4.** Wärmemuster-Sensor (100) nach einem der vorhergehenden Ansprüche, ferner umfassend eine dielektrische Schicht, welche die obere Elektrode jedes Pixels (102) der Matrix bedeckt, und eine erste elektrisch leitende Schicht, die auf der besagten dielektrischen Schicht angeordnet ist.

**5.** Wärmemuster-Sensor (100) nach Anspruch 1, wobei: eine zweite der unteren und oberen Elektroden jedes Pixels (102) durch eine zweite elektrisch leitende Schicht (138) gebildet wird, die allen Pixeln (102) der Matrix gemeinsam ist und dazu eingerichtet ist, elektrisch mit einem elektrischen Referenzpotential verbunden zu werden, und in jeder Zeile von Pixeln (102) mindestens ein zweiter elektrisch leitender Abschnitt (130) die Heizelemente der Pixel (102) bildet.

**6.** Wärmemuster-Sensor (100) nach Anspruch 5, wobei die zweite elektrisch leitende Schicht (138) zwischen den Heizelementen (130) und den Ausleseelektroden (112) angeordnet ist.

**7.** Wärmemuster-Sensor (100) nach einem der Ansprüche 3, 5 und 6, wobei jeder zweite elektrisch leitende Abschnitt (130) in jedem Pixel (102) Teile aufweist, deren elektrischer Widerstand größer ist als der des Rests des besagten zweiten elektrisch leitenden Abschnitts (130).

8. Wärmemuster-Sensor (100) nach einem der vorhergehenden Ansprüche, wobei für jede Zeile von Pixeln (102) die Heizelemente (116, 130) jedes Pixels (102) der besagten Zeile elektrisch miteinander verbunden sind und durch mindestens einen zweiten elektrisch leitenden Abschnitt (116, 130) gebildet werden, der von den Heizelementen der anderen Zeilen von Pixeln (102) verschieden ist und dazu eingerichtet ist, gleichzeitig alle Abschnitte aus pyroelektrischem Material (106) der Pixel (102) der besagten Zeile zu erwärmen.

9. Wärmemuster-Sensor (100) nach einem der vorhergehenden Ansprüche, wobei die Ausleseelektroden den unteren Elektroden der Pixel (102) entsprechen.

10. Wärmemuster-Sensor (100) nach einem der Ansprüche 1 bis 8, wobei die Ausleseelektroden den oberen Elektroden der Pixel (102) entsprechen.

11. Wärmemuster-Sensor (100) nach einem der vorhergehenden Ansprüche, wobei jedes der Heizelemente mehrere übereinanderliegende elektrisch leitende Abschnitte (150, 152, 156) aufweist.

12. Verfahren zur Herstellung eines Wärmemuster-Sensors (100), umfassend eine Matrix aus mehreren Zeilen und Spalten von Pixeln (102), umfassend mindestens die Durchführung der folgenden Schritte: Herstellen, für jedes Pixel (102), einer pyroelektrischen Kapazität, die durch mindestens einen Abschnitt aus pyroelektrischem Material (106) gebildet ist, der zwischen einer unteren Elektrode (108, 112) und einer oberen Elektrode (110, 114, 130, 145) angeordnet ist, wobei eine erste der unteren (108, 112) und oberen (110, 114, 130, 145) Elektroden einer Ausleseelektrode des Pixels (102) entspricht, und Herstellen eines Heizelements (116, 130, 145), das dazu eingerichtet ist, den Abschnitt aus pyroelektrischem Material (106) der pyroelektrischen Kapazität des besagten Pixels (102) während einer Messung des Wärmemusters durch die pyroelektrische Kapazität des besagten Pixels (102) zu erwärmen, und wobei: für jede Zeile von Pixeln (102) die Heizelemente (116, 130, 145) der Pixel (102) der besagten Zeile dazu eingerichtet sind, die Abschnitte aus pyroelektrischem Material (106) der Pixel (102) der besagten Zeile unabhängig von den Heizelementen (116, 130, 145) der Pixel (102) der anderen Zeilen zu erwärmen, wodurch eine Auswahl der besagten Zeile von Pixeln (102) für eine Messung des Wärmemusters durch die pyroelektrischen Kapazitäten der Pixel (102) der besagten Zeile realisiert wird, und wobei das Verfahren **dadurch gekennzeichnet ist, dass**: für jede Spalte von Pixeln (102) die Ausleseelektroden jedes Pixels (102) der besagten Spalte elektrisch miteinander verbunden sind und durch einen selben ersten elektrisch leitenden Abschnitt (112) gebildet werden, der sich über die gesamte Länge der Spalte von Pixeln (102) erstreckt und der in Kontakt mit den Abschnitten aus pyroelektrischem Material (106) der Pixel (102) der besagten Spalte steht und von den ersten elektrisch leitenden Abschnitten (112), welche die Ausleseelektroden der Pixel (102) der anderen Spalten bilden, verschieden ist, wodurch ein spaltenweises Auslesen von Ladungsänderungen realisiert wird, die in einer Zeile von Pixeln (102) während einer Messung des Wärmemusters durch die pyroelektrischen Kapazitäten der Pixel (102) der besagten Zeile erzeugt werden.

13. Verfahren nach Anspruch 12, wobei die Herstellung der unteren Elektroden (108) der Pixel (102) und/oder der oberen Elektroden (110) der Pixel (102) und/oder der Heizelemente (116, 130, 145) der Pixel (102) die Durchführung mindestens einer Abscheidung durch Drucken mindestens eines elektrisch leitenden Materials umfasst.

**Claims**

1. Thermal pattern sensor (100) comprising a matrix of several rows and columns of pixels (102), each pixel (102) comprising at least: a pyroelectric capacitor formed by at least one portion of pyroelectric material (106) disposed between a lower electrode (108, 112) and an upper electrode (110, 114, 130, 145), wherein a first one of the lower (108, 112) and upper (110, 114, 130, 145) electrodes corresponds to a reading electrode of the pixel (102), and a heating element (116, 130, 145) adapted to heat the portion of pyroelectric material (106) of the pyroelectric capacitor of said pixel (102) during a measurement of the thermal pattern by the pyroelectric capacitor of said pixel (102), and wherein: for each row of pixels (102), the heating elements (116, 130, 145) of the pixels (102) of said row are adapted to heat the portions of pyroelectric material (106) of the pixels (102) of said row independently of the heating elements (116, 130, 145) of the pixels (102) of the other rows, thus performing a selection of said row of pixels (102) for a measurement of the thermal pattern by the pyroelectric capacitors of the pixels (102) of said row, and the sensor being **characterized in that**: for each column of pixels (102), the reading electrodes of each pixel (102) of said column are electrically connected to each other and formed by a same first electrically conductive portion (112) which extends over the entire length of the column of pixels (102) and which is in contact with the portions of pyroelectric material (106) of the pixels (102) of said column and distinct from the first electrically conductive portions (112) forming the reading electrodes of the pixels (102) of the other columns, performing a reading in columns of variations of charges generated in a row of pixels (102) during a measurement of the thermal pattern by the pyroelectric capacitors of the pixels (102) of said row.

2. Thermal pattern sensor (100) according to claim 1, wherein: in each pixel (102), a second one of the lower and upper electrodes corresponds to a polarization electrode (114) of the pixel (102) distinct from the heating elements (116), and in each row of pixels (102), the heating elements (116) and the polarization electrodes (114) of the pixels (102) of said row are juxtaposed and disposed on or under the portions of pyroelectric material (106) of the pixels (102) of said row.

3. Thermal pattern sensor (100) according to claim 1, wherein, in each row of pixels (102), at least one second electrically conductive portion (130) forms both the heating element and a second one of the lower and upper electrodes of each of the pixels (102) of said row.

4. Thermal pattern sensor (100) according to one of the preceding claims, further comprising a dielectric layer covering the upper electrode of each pixel (102) of the matrix and a first electrically conductive layer disposed on said dielectric layer.

5. Thermal pattern sensor (100) according to claim 1, wherein: a second one of the lower and upper electrodes of each pixel (102) is formed by a second electrically conductive layer (138) common to all the pixels (102) of the matrix and adapted to be electrically connected to a reference electrical potential, and in each row of pixels (102), at least one second electrically conductive portion (130) forms the heating elements of the pixels (102).

6. Thermal pattern sensor (100) according to claim 5, wherein the second electrically conductive layer (138) is disposed between the heating elements (130) and the reading electrodes (112).

7. Thermal pattern sensor (100) according to one of claims 3, 5 and 6, wherein each second electrically conductive portion (130) comprises, in each pixel (102), parts whose electrical resistance is greater than that of the remainder of said second electrically conductive portion (130).

8. Thermal pattern sensor (100) according to one of the preceding claims, wherein, for each row of pixels (102), the heating elements (116, 130) of each pixel (102) of said row are electrically connected to each other and formed by at least one second electrically conductive portion (116, 130) distinct from the heating elements of the other rows of pixels (102) and adapted to simultaneously heat all the portions of pyroelectric material (106) of the pixels (102) of said row.

9. Thermal pattern sensor (100) according to one of the preceding claims, wherein the reading electrodes correspond to the lower electrodes of the pixels (102).

10. Thermal pattern sensor (100) according to one of claims 1 to 8, wherein the reading electrodes correspond to the upper electrodes of the pixels (102).

11. Thermal pattern sensor (100) according to one of the preceding claims, wherein each of the heating elements comprises several superimposed electrically conductive portions (150, 152, 156).

12. Method for producing a thermal pattern sensor (100) comprising a matrix of several rows and columns of pixels (102), comprising at least the implementation of the following steps: production, for each pixel (102), of a pyroelectric capacitor formed by at least one portion of pyroelectric material (106) disposed between a lower electrode (108, 112) and an upper electrode (110, 114, 130, 145), wherein a first one of the lower (108, 112) and upper (110, 114, 130, 145) electrodes corresponds to a reading electrode of the pixel (102), and production of a heating element (116, 130, 145) adapted to heat the portion of pyroelectric material (106) of the pyroelectric capacitor of said pixel (102) during a measurement of the thermal pattern by the pyroelectric capacitor of said pixel (102), and wherein: for each row of pixels (102), the heating elements (116, 130, 145) of the pixels (102) of said row are adapted to heat the portions of pyroelectric material (106) of the pixels (102) of said row independently of the heating elements (116, 130, 145) of the pixels (102) of the other rows, thus performing a selection of said row of pixels (102) for a measurement of the thermal pattern by the pyroelectric capacitors of the pixels (102) of said row, and the method being **characterized in that**: for each column of pixels (102), the reading electrodes of each pixel (102) of said column are electrically connected to each other and formed by a same first electrically conductive portion (112) which extends over the entire length of the column of pixels (102) and which is in contact with the portions of pyroelectric material (106) of the pixels (102) of said column and distinct from the first electrically conductive portions (112) forming the reading electrodes of the pixels (102) of the other columns, performing a reading in columns of variations of charges generated in a row of pixels (102) during a measurement of the thermal pattern by the pyroelectric capacitors of the pixels (102) of said row.

13. Method according to claim 12, wherein the production of the lower electrodes (108) of the pixels (102) and/or of the upper electrodes (110) of the pixels (102) and/or of the heating elements (116, 130, 145) of the pixels (102) comprises the implementation of at least one deposition by printing of at least one electrically conductive material.

FIG.1

FIG.2

FIG.3

FIG.4

FIG.5

132  102  140 142 112  130                    134          100

136

y
z → x

# FIG.6

102
152                                    109
156
154                                    150
106
108

104

z
y → x

# FIG.7

FIG.8

**EP 3 654 242 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4394773 A
- US 4429413 A
- US 6289114 B
- US 6091837 A
- EP 2385486 A1